# EUROPÄISCHE PATENTANMELDUNG

(11) **EP 0 743 743 A2**
(43) Veröffentlichungstag der Anmeldung: **20.11.1996**
(21) Anmeldenummer: 96201136.7
(22) Anmeldetag: 08.05.1996
(51) Int. Cl.: H02M 3/00

(54) **Schaltkreis für einen der Stromversorgung dienenden Sperrwandler**

(30) Priorität: 13.05.1995 DE 19517703
(71) Anmelder: FRIWO Gerätebau GmbH, 48346 Ostbevern (DE)
(72) Erfinder: Bothe, Michael, 49549 Ladbergen (DE)
(74) Vertreter: Ackmann, Günther, Dr.-Ing.

(57) **Zusammenfassung**

Um einen Schaltkreis für einen der Stromversorgung dienenden Sperrwandler mit getakteter Gleichspannung, bestehend aus einem eine Gleichspannung zerhackenden primärseitigen, mit einer Schutzschaltung versehenen Leistungstransistor (T1) einem sekundären Leistungstransistor (D1) und einem der Potentialtrennung dienenden Transformator, als Hybridschaltkreis mit integrierten Kondensatoren auszubilden, ist der Schaltkreis als Hybridschaltkreis auf einem keramischen Substrat (1) mit einer relativen Dielektrizitätskonstanten größer als 1000 ausgebildet und die dem Schaltkreis zugehörigen Kondensatoren (C1, C2, C3) bestehen jeweils aus zwei flächigen Leiterschichten, die auf beiden Seiten des Substrats (1) parallel zueinander angeordnet sind.

## Beschreibung

Die Erfindung betrifft einen Schaltkreis für einen der Stromversorgung dienenden Sperrwandler mit getakteter Gleichspannung mit den im Oberbegriff des Anspruches 1 angegebenen Merkmalen.

Bei Sperrwandlern mit getakteter Gleichspannung und mit Potentialtrennung, z. B. durch einen Transformator, sind zwischen der Primär- und Sekundärseite Sicherheitskondensatoren erforderlich, wobei deren Spannungsfestigkeit bis zu 3 kV betragen und das Dielektrikum wenigstens 1 mm dick sein soll. Sicherheitsvorschriften verlangen außerdem, daß zwischen den Bauelementen der Primär- und Sekundärseite ein Mindestabstand einzuhalten ist und eine Prüfspannung größer als 4 kV zu gewährleisten ist. Diese Anforderungen lassen die Herstellung einer kompletten Schaltung in der Art einer Hybridschaltung nicht ohne weiteres zu. In der Regel werden für integrierte Schaltungen Substrate mit einer Dielektrizitätskonstante von etwa 10 verwendet. Aus DE 40 24 146 Al und DE 41 34 753 Al sind für spezielle HF-Schaltungen auch Substrate aus Keramik, z. B. Bariumtitanat, mit einer Dielektrizitätskonstante εᵣ > 40 bzw. 80 bekannt. Da die Kapazität eines Kondensators um so größer ist, je höher die Dielektrizitätskonstante des Dielektrikums, je größer die Elektrodenfläche und je kleiner der Elektrodenabstand ist, wird zunächst die Einbeziehung von Kondensatoren in integrierte Schaltungen durch einen großen Flächenbedarf begrenzt. Diese bekannten integrierten Kondensatoren finden im wesentlichen bei HF-Schaltungen Verwendung, bei denen der frequenzabhängige Kapazitätsverlust sehr gering ist, während bei niedrigen Frequenzen ein relativ hoher Kapazitätsverlust auftritt. Insbesondere geben die bekannten Substrate mit einer Dielektrizitätskonstante unter 80 nicht die erforderliche Spannungsfestigkeit für die den Sperrwandlern zugeordneten Schutz- und Sicherheitskondensatoren.

Der Erfindung liegt daher die Aufgabe zugrunde, einen Schaltkreis der gattungsgemäßen Art als Hybridschaltkreis mit integrierten Kondensatoren auszubilden.

Diese Aufgabe wird durch die im Kennzeichen des Anspruchs 1 angegebenen Merkmale gelöst.

Die Verwendung eines keramischen Trägerwerkstoffs mit einer relativen Dielektrizitätskonstante größer als 1000, die gegenüber den bekannten keramischen Trägerwerkstoffen erheblich größer ist, läßt eine so hohe effektive Kapazität als Plattenkondensator zu, daß auch Sicherheitskondensatoren integriert werden können, indem die Leiterschichten beidseitig auf das Substrat aufgetragen werden. Insoweit verwendet die Erfindung eine keramischen Trägerwerkstoff, wie er für Keramik-Einschichtkondensatoren als Dielektrikum Verwendung findet, wobei jedoch diese Kondensatoren selbständige Bauelemente darstellen, die mit gedruckten Schaltungen verdrahtet werden. Durch die Integration von Kondensatoren und Leistungstransistoren wird die Baugröße erheblich verringert. Außerdem gewährleistet das Substrat eine gute Ableitung der Verlustwärme der Leistungstransistoren.

Die Baugröße läßt sich weiter dadurch verringern, daß ein Substrat mit einer relativen Dielektrizitätskonstante zwischen 2000 und 6000 gewählt wird. Zweckmäßig hat das Substrat eine Dicke von wenigstens 1 mm. In vorteilhafter Weise können zwischen der Primär- und Sekundärseite integrierte Sicherheitskondensatoren vorgesehen sein. Weiterhin kann einem primärseitigen integrierten Leistungstransistor ein RC-Glied parallel geschaltet sein, dessen Widerstand und Kondensator als integrierte Bauelemente ausgebildet sind. Auf der Sekundärseite kann als Leistungstransistor wahlweise eine Einzeldiode oder eine Doppeldiode oder ein FET-Transistor vorgesehen sein, wodurch anstatt eines Sperrwandlers auch ein Flußwandler realisierbar ist oder die Sekundärspannung des Transformators synchron gleichgerichtet wird, um die Verluste der Gleichrichtung insbesondere für kleine Ausgangsspannungen zu reduzieren. Damit zwischen den primär- und sekundärseitigen Sicherheitskondensatoren einer Prüfspannung von mindestens 4 kV erreicht werden kann, beträgt der Abstand zwischen diesen Sicherheitskondensatoren wenigstens 8 mm. Weiterhin beträgt die Spannungsfestigkeit der Sicherheitskondensatoren wenigstens 3 kV.

Ein Ausführungsbeispiel der Erfindung ist in der Zeichnung dargestellt; es zeigt
- Fig. 1: einen Hybridschaltkreis in einer Ansicht von oben,
- Fig. 2: den Gegenstand der Fig. 1 in einer Ansicht von unten,
- Fig. 3: den Gegenstand der Fig. 1 in einer Seitenansicht und
- Fig. 4: den Schaltplan des in den Fig. 1 bis 3 gezeigten Hybridschaltkreises.

Der in der Zeichnung dargestellte Hybridschaltkreis bildet einen Sperrwandler mit einem Transformator. Er hat eine DC/DC-Wandlertopologie mit Potentialtrennung und kann beispielsweise in Stromversorgungen bis etwa 100 W Verwendung finden. Mit ihm wird eine Gleichspannung mittels eines Leistungstransistors zerhackt, und die pulsierende Spannung wird mittels des Transformators in eine andere Spannung umgeformt, die auf der Sekundärseite durch eine Diode gleichgerichtet wird.

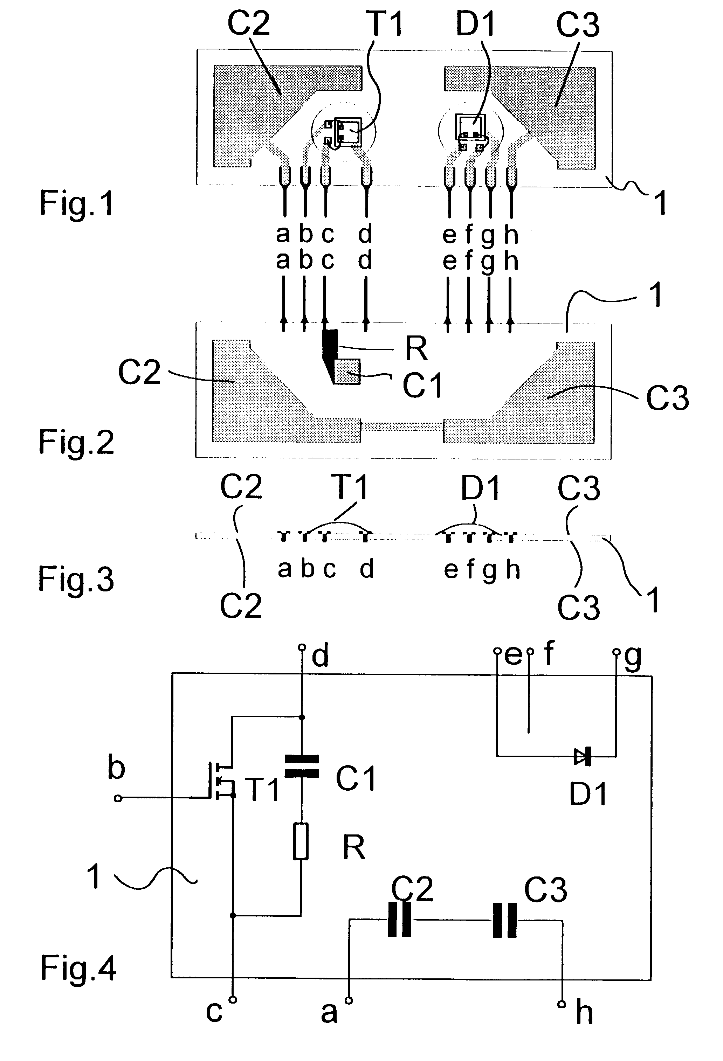

Der in den Fig. 1 bis 3 dargestellte Hybridschaltkreis ist auf einem Substrat 1 aus einem keramischen Werkstoff angebracht, dessen relative Dielektrizitätskonstante größer als 1000 ist und vorzugsweise zwischen 2000 und 5000 liegt. Zu dieser Werkstoffgruppe gehören z. B. Oxidkeramik, Bariumtitanat u. dgl., deren relative Dielektrizitätskonstante bis zu etwa 5500 reicht. Die Platte ist im Ausführungsbeispiel 1 mm dick und ihre Grundfläche beträgt etwa 50 x 16 mm. Wie der Schaltplan nach Fig. 4 zeigt, ist auf der Primärseite ein eine Gleichspannung zerhackender FET-Transistor T1 vorgesehen, dem ein RC-Glied, bestehend aus einem Widerstand R und einem Kondensator C1, parallel geschaltet ist. Zugeordnet sind Anschlußbeine c,d für die Primärspannung und ein Anschluß b für die Steuerspannung. Auf der Sekundärseite ist eine Gleichrichterdiode D1 mit Anschlußbeinen e,g angeordnet. Ein Anschlußbein f ist vorsorglich vorgesehen, um bedarfsweise anstelle der Gleichrichterdiode einen steuerbaren Transistor, z. B. einen FET-Transistor integrieren und mit einer Steuerspannung versorgen zu können. Schließlich sind die primär- und sekundärseitigen Stromkreise durch zwei Sicherheitskondensatoren C2,C3 verbunden, denen Anschlußbeine a,h zugeordnet sind. Ein nicht dargestellter Transformator ist über die Anschlüsse d bzw. e an den Primär- bzw. Sekundärstromkreis angeschlossen.

Die Beschichtungsflächen für die Kondensatoren C1,C2 und C3 lassen sich aus der Kapazitätsformel für Plattenkondensatoren berechnen:

C = εᵣ εₒ A/d,

wobei
- C: die Kapazität des Kondensators,
- εᵣ: die relative Dielektrizitätskonstante des Substrats,
- εₒ: die Dielektrizitätskonstante des leeren Raums,
- A: die Fläche des Kondensators und
- d: die Dicke des Substrats ist.

Sollen beispielsweise die Werte für C1 = 220 pF und für C2 und C3 jeweils 2,2 nF betragen und findet ein Substrat mit εᵣ = 3000 und einer Dicke von 1 mm Verwendung, ergibt sich für C1 eine Fläche von A = 8,3 mm2 und für C2 und C3 jeweils A = 83 mm2. Die metallische Beschichtung kann dann beispielsweise in der in Fig. 1 bis 3 dargestellten Flächenanordnung vorgenommen werden, wobei C2 und C3 zu den Enden hin angeordnet sind und Cl mehr zur Mitte liegt. T1 ist, auch wieder beispielhaft, über einer Beschichtung des Kondensators C1 aufgebracht. Für eine Prüfspannung von 4 kV und höher zwischen den Sicherheitskondensatoren C2, C3 der Primär- und Sekundärseite beträgt deren Abstand zueinander wenigstens 8 mm. Außerdem sind die Sicherheitskondensatoren C2, C3 jeweils so ausgebildet, daß ihre Spannungsfestigkeit wenigstens einer Prüfspannung von 3 kV entspricht. Der Abstand zwischen den Anschlußbeinen a, b, c, der Primärseite und e, f, g, h der Sekundärseite beträgt mindestens 2,5 mm, der zwischen c und d wenigstens 5 mm und der zwischen d und e 10 mm.

Die Herstellung des Hybridschaltkreises kann in folgenden Schritten erfolgen:
- Brennen des Keramikwerkstoffs zu Substraten von 4x4 Zoll,
- Vorritzen durch Laser in Einzelplatten
- Bedrucken der oberen und unteren Fläche des Substrats mit Metallisierungspaste und Widerstandspaste
- Bestücken, Verlöten und Bonden der Leistungstransistoren T1 und D1,
- Abdecken der Leistungstransistoren mit Epoxidharz
- Vereinzeln zu Streifen
- Anbringen der Anschlußbeine an die Streifen
- Vereinzeln zu Einzelplatten und Tauchlackieren.

Der entsprechend den Fig. 1 bis 4 ausgebildete Hybridschaltkreis kann dann zu einem Sperrwandler vervollständigt werden. Hierfür werden die Anschlüsse d und e mit dem Primär- bzw. Sekundärkreis eines Transformators (nicht dargestellt) verbunden, der wiederum an die primäre Gleichstromquelle bzw. an den sekundären Verbraucher angeschlossen wird. Die primärseitigen Anschlüsse a und c werden mit dem negativen Pol (Masse) der Gleichstromquelle und der sekundärseitige Anschluß h wird mit dem Massepol des Verbraucherstromkreises verbunden. An dem Anschluß b wird die Steuerstromleitung für den FET-Transistor T1 angeschlossen. Bei der Ausführung nach Fig. 4 ist sekundärseitig eine einfache Gleichrichterdiode D1 vorgesehen, so daß der Anschluß f frei ist. Doch kann anstelle der Gleichrichterdiode D1 eine Doppeldiode vorgesehen werden, die über die Anschlüsse e und f gespeist wird. Wird sekundärseitig ein FET-Transistor verwendet, kann die Sekundärspannung des Transformators synchron zur Primärspannung gleichgerichtet werden, wodurch sich die Leitverluste der Gleichrichtung insbesondere für kleine Ausgangsspannungen reduzieren lassen.

## Patentansprüche

1. Schaltkreis für einen der Stromversorgung dienenden Sperrwandler mit getakteter Gleichspannung, bestehend aus einem eine Gleichspannung zerhackenden primärseitigen, mit einer Schutzschaltung versehenen Leistungstransistor einem sekundären Leistungstransistor und einem der Potentialtrennung dienenden Transformator, dadurch gekennzeichnet, daß der Schaltkreis als Hybridschaltkreis auf einem keramischen Substrat mit einer relativen Dielektrizitätskonstanten größer als 1000 ausgebildet ist und die dem Schaltkreis zugehörigen Kondensatoren (Cl, C2, C3) jeweils aus zwei flächigen Leiterschichten bestehen, die auf beiden Seiten des Substrats parallel zueinander angeordnet sind.

2. Schaltkreis nach Anspruch 1, dadurch gekennzeichnet, daß die relative Dielektrizitätskonstante des Substrats (1) zwischen 2000 und 6000 liegt.

3. Schaltkreis nach Anspruch 1 oder 2, dadurch gekennzeichnet, daß das Substrat (1) eine Dicke von wenigstens 1 mm aufweist.

4. Schaltkreis nach einem der Ansprüche 1 bis 3, dadurch gekennzeichnet, daß zwischen der Primär- und Sekundärseite integrierte Sicherheitskondensatoren (C2, C3) vorgesehen sind.

5. Schaltkreis nach einem der Ansprüche 1 bis 4, dadurch gekennzeichnet, daß einem primärseitigen integrierten Leistungstransistor (T1) ein RC-Glied parallel geschaltet ist, dessen Widerstand (R) und Kondensator (C1) als integrierte Bauelemente ausgebildet sind.

6. Schaltkreis nach einem der Ansprüche 1 bis 5, dadurch gekennzeichnet, daß auf der Sekundärseite als Leistungstransistor eine Einzeldiode oder eine Doppeldiode oder ein FET-Transistor vorgesehen ist.

7. Schaltkreis nach einem der Ansprüche 1 bis 6, dadurch gekennzeichnet, daß der Abstand zwischen den Sicherheitskondensatoren (C2, C3) der Primär- und Sekundärseite wenigstens 8 mm beträgt.

8. Schaltkreis nach einem der Ansprüche 1 bis 7, dadurch gekennzeichnet, daß die Spannungsfestigkeit der Sicherheitskondensatoren (C2, C3) wenigstens einer Prüfspannung von 3 kV entspricht.
